Europäisches Patentamt

European Patent Office

Office européen des brevets

(19)

(11) Veröffentlichungsnummer : **0 480 145 B1**

(12) # EUROPÄISCHE PATENTSCHRIFT

(45) Veröffentlichungstag der Patentschrift :
**14.06.95 Patentblatt 95/24**

(51) Int. Cl.⁶ : **H03D 9/06**

(21) Anmeldenummer : **91113801.4**

(22) Anmeldetag : **17.08.91**

(54) **Modulator- und Mischstufe.**

(30) Priorität : **07.09.90 DE 4028371**

(43) Veröffentlichungstag der Anmeldung :
**15.04.92 Patentblatt 92/16**

(45) Bekanntmachung des Hinweises auf die Patenterteilung :
**14.06.95 Patentblatt 95/24**

(84) Benannte Vertragsstaaten :
**DE ES FR GB IT NL SE**

(56) Entgegenhaltungen :
**EP-A- 0 063 819**
**DE-A- 2 944 642**
**Proceedings of the 32nd Midwest Symposium on Circuits and Systems, August14-16,1989, pages 1046-1049, New York, USA. Nassef et al. : "Practical designof microstrip mixer circuits"**
**PATENT ABSTRACTS OF JAPAN vol. 6, no. 72 (E-105)(950) 7.**
**Mai 1982 & JP-A-57 011 506 ( HITACHI SEISA-KUSHO K.K. ) 21. Januar 1982**

(56) Entgegenhaltungen :
**PATENT ABSTRACTS OF JAPAN vol. 6, no. 136 (E-120)(1014)23. Juli 1982 & JP-A-57 061 311 ( TOKYO SHIBAURA DENKI K.K. ) 13. April 1982**

(73) Patentinhaber : **Alcatel SEL Aktiengesellschaft**
**Lorenzstrasse 10**
**D-70435 Stuttgart (DE)**
(84) **DE**
Patentinhaber : **ALCATEL N.V.**
**Strawinskylaan 341,**
**(World Trade Center)**
**NL-1077 XX Amsterdam (NL)**
(84) **ES FR GB IT NL SE**

(72) Erfinder : **Müller, Fred-Egon, Dr.**
**Allmendstrasse 41**
**W-7530 Pforzheim 13 (DE)**

(74) Vertreter : **Pohl, Herbert, Dipl.-Ing et al**
**Alcatel SEL AG**
**Patent- und Lizenzwesen**
**Postfach 30 09 29**
**D-70449 Stuttgart (DE)**

EP 0 480 145 B1

## Beschreibung

Die Erfindung betrifft eine Modulatorstufe gemäß dem Oberbegriff von Anspruch 1 und deren Verwendung als Mischstufe.

Zur Übertragung von digitalen Nachrichten werden die Signale mit einem Modulator auf einen Träger moduliert. Ein bekanntes Prinzip eines Direktmodulators, der in Transmission arbeitet, weist einen Träger- und Signaleingang und einen Signalausgang auf, die wie folgt verknüpft sind. Der Trägereingang und der Signalausgang sind über zwei Wege miteinander verbunden, wobei auf einem Weg ein Phasenverzögerungsglied angeordnet ist. Ferner ist auf jedem der beiden Wege ein nichtlineares Halbleiterbauelement derart angeordnet, daß die nichtlinearen Halbleiterbauelemente aufgrund ihrer Polarität und der Anordnung des Phasenverzögerungsgliedes, das eine Phasenverzögerung um 180° bewirkt, bezüglich des Trägers im Gleichtakt schalten. Hierdurch wird am Signalausgang der Träger unterdrückt. Liegt nun ein Signal in Form einer Modulationsspannung an dem Verzögerungsweg an, schalten die nichtlinearen Halbleiterbauelemente bezüglich der Modulationsspannung im Gegentakt, was die Modulation des Trägers am Signalausgang bewirkt. Ein solcher Modulator kann auch als Mischstufe verwendet werden. Eine spezielle Struktur eines nach dem o.g. Prinzip arbeitenden Modulators und dessen Verwendung als Mischer ist in der DE-PS 29 44 642 beschrieben. Das Phasenverzögerungsglied des beschriebenen Modulators besteht aus einem Leiterstück mit der Länge $\frac{\lambda}{2}$ der Mittenfrequenz des Trägers.

Der bekannte Amplitudenmodulator weist nun aufgrund der fest vorgegebenen Länge des Phasenverzögerungsgliedes eine vorbestimmte Länge, nämlich $\frac{\lambda}{2}$ des Trägers auf.

Der Erfindung liegt die Aufgabe zugrunde, eine Modulatorstufe zu schaffen, bei der die Länge und die Form des Phasenverzögerungsgliedes an den restlichen Teil der Modulatorschaltung geometrisch und elektrisch flexibel anpaßbar ist.

Diese Aufgabe wird bei einer gattungsgemäßen Anordnung durch die Merkmale des Anspruchs 1 gelöst.

Ein besonderer Vorteil der Erfindung liegt darin, daß auch parasitäre Komponenten bei der Ausgestaltung des Tiefpasses berücksichtigt werden können.

Weitere Ausgestaltungen der Erfindung sind den übrigen Ansprüchen und dem folgenden Teil der Beschreibung zu entnehmen.

Die ausführliche Beschreibung der Erfindung erfolgt anhand der Figuren 1 bis 6 bezogen auf Ausführungsbeispiele von Modulatorstufen. Die Verwendung als Mischstufe wird am Ende der Beschreibung erläutert. Es zeigen:

Fig. 1  ein erstes Ausführungsbeispiel einer erfindungsgemäßen Modulatorstufe,

Fig. 2  das Ersatzschaltbild des Verzögerungsgliedes aus Fig. 1,

Fig. 3  eine schematische Darstellung der erfindungsgemäßen Doppelmodulatorstufe,

Fig. 4  ein zweites Ausführungsbeispiel in Form einer Doppelmodulatorstufe in Streifenleitertechnik ausgebildet, für hohe Trägerfrequenzen,

Fig. 5  ein drittes Ausführungsbeispiel in einer Doppelmodulatorstufe mit diskreten Bauelementen aufgebaut, für niedrige Frequenzen, und

Fig. 6  eine schematische Darstellung eines 16 QAM-Modulators.

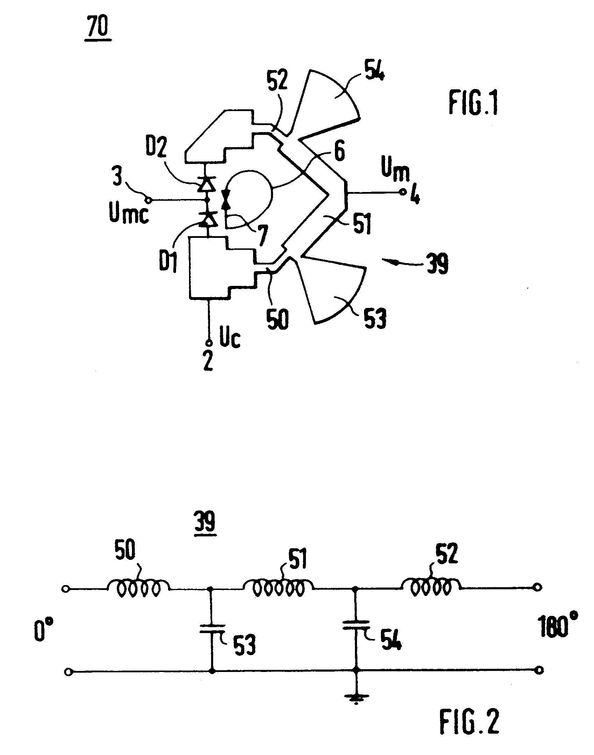

Die in Fig. 1 abgebildete Modulatorstufe 70 ist in planarer Streifenleitertechnik aufgebaut und weist einen Trägereingang 2, einen Signaleingang 4 und einen Signalausgang 3 auf. Am Trägereingang 2 liegt der Träger mit der Spannung $U_c$, am Signalausgang 3 der modulierte Träger mit der Spannung $U_{mc}$ und am Signaleingang 4 ein digitales Signal mit der Modulationsspannung $U_m$ an. Vom Trägereingang 2 zum Signalausgang 3 der Modulatorstufe 70 führen zwei Wege, ein elektrisch kurzer Weg 7 und ein Phasenverzögerungsweg 6, auf dem sich ein Phasenverzögerungsglied befindet, das die Phase des Trägers $U_c$ idealerweise um 180° oder ein ungeradzahliges, ganzes Vielfaches von 180° verzögert. Vom Trägereingang 2 aus wird jedem der beiden Wege die gleiche Leistung mit gleicher Phasenlage zugeführt. Auf jedem der beiden Wege ist eine Halbleiterdiode $D_1$, $D_2$ angeordnet, die bezüglich des Signalausgangs 3 entgegengesetzte Polarität aufweisen.

Die Halbleiterdiode $D_2$ auf dem Phasenverzögerungsweg 7 ist bezogen auf die Ausbreitungsrichtung des Trägers hinter dem Phasenverzögerungsglied angeordnet, so daß die beiden Halbleiterdioden $D_1$ und $D_2$ bezüglich des Trägers im Gleichtakt schalten. Beim bisher beschriebenen Teil der Modulatorstufe 70 herrscht, aufgrund der Anordnung der Halbleiterdioden $D_1$ und $D_2$ und der Ausgestaltung der beiden Übertragungswege 6, 7 am Signalausgang 3 im Idealfall Trägerspannungsunterdrückung, da die Schaltung wie eine Brücke wirkt. Im Realfall ist eine Optimierung der Trägerspannungsunterdrückung notwendig. Hierzu weist die Modulatorstufe 70 zum Abgleich im unmodulierten Zustand einen regelbaren Widerstand $R_R$ auf, der am Potential $U_g$ anliegt und mit dem Signaleingang 4 verbunden ist (nicht abgebildet).

Mit dem Phasenverzögerungsweg 6 ist der Signaleingang 4 verbunden, über den die Modulationsspannung $U_m$ angelegt wird, die ein Schalten der beiden Halbleiterdioden $D_1$ und $D_2$ im Gegentakt bewirkt. Wie eine solche Wirkung erzielbar ist, wird aus der Beschreibung der Ausführungsbeispiele noch verdeutlicht.

Der Signaleingang 4 ist mit einem Tiefpaß 18, 19 und der Signalausgang 3 mit einem Hochpaß 20 versehen.

Liegt nun am Signaleingang 4 eine Modulationsspannung $U_m$ mit ausreichend hoher Amplitude zum Aussteuern der Halbleiterdioden $D_1$ und $D_2$ an, so sperrt die eine Halbleiterdiode $D_1$ und die andere Halbleiterdiode $D_2$ ist nichtsperrend, wodurch am Signalausgang 3 die volle Trägerspannung $U_c$ anliegt. Ändert man das Vorzeichen von $U_m$, dann ändert sich auch das Vorzeichen von $U_{mc}$, was als Phasenumschaltung zu betrachten ist.

Um Amplitudenlinearität zu erreichen, werden an den Signaleingang 4 kleinere Modulationsspannungen $U_m$ angelegt, wodurch die eine Halbleiterdiode, z.B. $D_1$, weniger als die andere Halbleiterdiode, z.B. $D_2$, durchschaltet. Das Gleichgewicht wird hierdurch am Signalausgang 3 nur verschoben und somit eine resultierende, modulierte Trägerspannung $U_{mc}$ erzeugt.

Der Betrag der modulierten Trägerspannung $U_{mc}$ hängt vom Betrag der Modulationsspannung $U_m$ und die Phase vom Vorzeichen der Modulationsspannung $U_m$ ab. Liegt nun z.B. am Signaleingang 4 eine positive Modulationsspannung $U_m$ an, so ist die Halbleiterdiode $D_1$ stärker leitend als die Halbleiterdiode $D_2$, wodurch der elektrisch kurze Weg 7 gegenüber dem Phasenverzögerungsweg 6 niederohmiger ist, und die Übertragung über den elektrisch kurzen Weg 7 dominiert. Weist die Modulationsspannung $U_m$ einen negativen Betrag auf, verhält es sich gerade umgekehrt.

Das Phasenverzögerungsglied ist erfindungsgemäß als Tiefpaß 39 ausgebildet. Der in Fig. 1 abgebildete Tiefpaß 39 besteht aus drei Induktivitäten 50, 51, 52, die in Reihe geschaltet sind und zwei Kapazitäten 53, 54, die jeweils zwischen zwei Induktivitäten anliegen und mit Erdpotential gekoppelt sind, wie dies auch dem Ersatzschaltbild aus Fig. 2 zu entnehmen ist.

Die in Fig. 1 abgebildete Form des Tiefpasses 39, d.h. die Anzahl der Induktivitäten 50, 51, 52 und die Anzahl der Kapazitäten 53, 54, sowie die Ausgestaltung der Induktivitäten sind nicht zwingend.

Für eine Trägerfrequenz von 1 bis 10 GHz hat sich der oben beschriebene Tiefpaß 39 als vorteilhaft erwiesen. Dabei ist eine Grenzfrequenz $f_G$ im Bereich der zweiten Harmonischen der Trägerfrequenz besonders vorteilhaft.

Der oben beschriebene fünfstufige Tiefpaß 39 weist noch den besonderen Vorteil auf, daß einerseits die Frequenzabhängigkeit des Tiefpasses wegen der geringen Anzahl von Bauelementen relativ gering ist und andererseits die Flexibilität der geometrischen Ausbildung genügend Spielraum läßt, den elektrisch kurzen Weg 7 und den Phasenverzögerungsweg 6 mit dem Tiefpaß 39 miteinander zu verbinden.

Aus geometrischen Gründen hat es sich für in planarer Streifenleitertechnik hergestellte Modulatorschaltungen als vorteilhaft erwiesen, die beiden beiden Enden des Tiefpasses 39 als Induktivitäten 50 und 52 auszubilden.

Erfolgt der Schaltungsaufbau der Modulatorstufe in planarer Streifenleitertechnik, wird die Bemessung der Schaltung rechnergestützt durchgeführt (computer aided design: CAD). Hierbei können natürlich parasitäre Schaltungskomponenten sowie Herstellungstoleranzen der Streifenleiterstrukturen in die Berechnung mit einbezogen werden.

Der Schaltungsaufbau eignet sich auch zur Herstellung in MMIC-Technik (monolithic microwave integrated circuit). Dabei müssen die Ausführungsbeispiele der Technologie entsprechend modifiziert sein.

Da der elektrisch kurze Weg 7 und der Phasenverzögerungsweg 6 außer dem Phasenverzögerungsglied in der Realität noch weitere Ungleichheiten aufweisen, wird der Tiefpaß so bemessen sein, daß sich im Phasenverzögerungsweg 6 eine Verzögerung von 180° gegenüber dem elektrisch kurzen Weg 7 ergibt. Nur im Idealfall ergibt sich die Phasenverzögerung ausschließlich über den Tiefpaß 39.

Der Tiefpaß läßt sich auch mit diskreten Teilen aufbauen, dies wird vorzugsweise für Trägerfrequenzen im oberen MHz-Bereich der Fall sein.

Die beschriebene Modulatorstufe 70 stellt somit einen einfachen im Transmissionsbetrieb betriebenen Phasenumschalter dar, der als Teil eines digitalen Direktmodulators betrieben wird.

Bei der Realisierung einer solchen Modulatorstufe 70 kann man sich leicht vorstellen, daß das zur Trägerunterdrückung notwendige Brückengleichgewicht ebenso wie die Amplitudenlinearität durch z.B. die Ungleichheit der Halbleiterdioden und deren parasitärer Komponenten gestört werden, was zu einer Abweichung des idealen Verhaltens der Modulatorstufe 70 führt. Weiter erfolgt die Übertragung das eine Mal über den elektrisch kurzen Weg 7 und das andere Mal über den Phasenverzögerungsweg 6. Da die beiden Wege im Aufbau auch elektrisch ungleich sind, sind auch in den beiden Wegen die Gruppenlaufzeiten ungleich und führen zu hohen Frequenzabhängigkeiten, die durch zusätzliche Maßnahmen kompensiert werden müssen.

Diese Probleme sind durch die nachfolgend beschriebenen Ausführungsbeispiele gelöst.

EP 0 480 145 B1

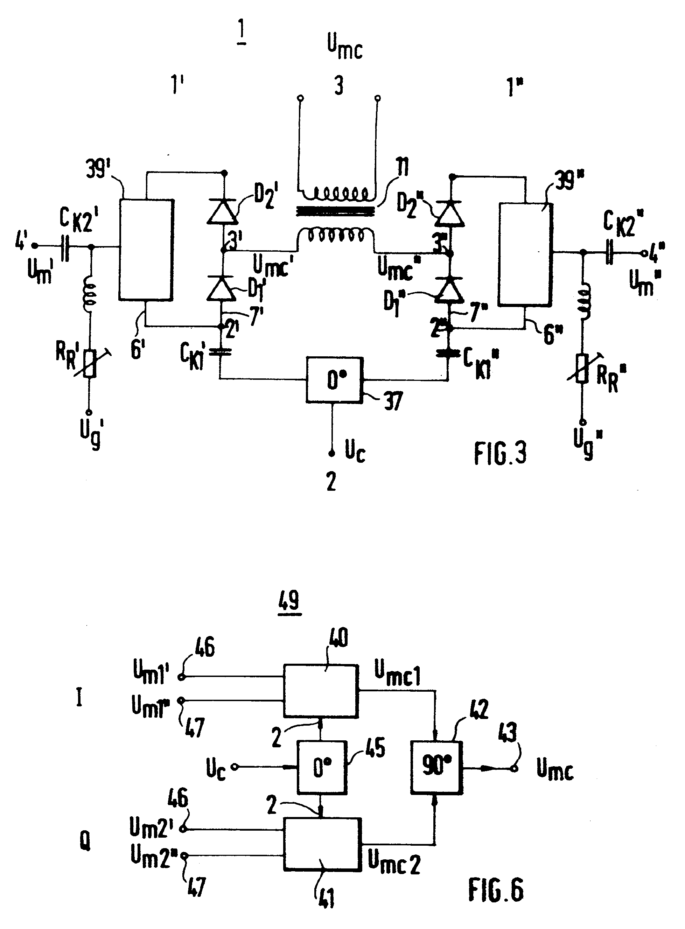

Das Problem der Trägerunterdrückung bei nicht anliegender Modulationsspannung $U_m$ wird bei der Erfindung im einen Punkt durch den regelbaren Widerstand $R_R'$ und im anderen Punkt durch den symmetrischen Aufbau einer Modulatorstufe 70 als nachfolgend beschriebene Doppelmodulatorstufe 1 nach Fig. 3 gelöst.

Die Doppelmodulatorstufe 1 setzt sich aus zwei gleichen Modulatorstufen 1′ und 1″ zusammen, die prinzipiell wie die Modulatorstufe 70 aufgebaut sind und die folgendermaßen miteinander verknüpft sind. Gleiche Teile der Modulatorstufen sind mit gleichen Bezugszeichen versehen. Weist das Bezugszeichen eines Merkmals zusätzlich einen Strich auf, so gehört dieses Merkmal zur Modulatorstufe 1′, weist das Bezugszeichen eines Merkmals zwei Striche auf, so gehört es zur Modulatorstufe 1″. Die beiden Trägereingänge 2′, 2″ sind über einen 0°-Leistungsteiler 37 zu einem gemeinsamen Trägereingang 2 der Doppelmodulatorstufe 1 zusammengefaßt und durch die Kondensatoren $C_{K1}'$, $C_{K1}''$ galvanisch entkoppelt. Die beiden Signalausgänge 3′, 3″ werden in einem Leistungskombinator, z.B. einem Übertrager 11, zusammengeführt, dessen Sekundärwicklung den Ausgang 3 der Gegentaktmodulatorstufe 1 bilde. Die beiden Signaleingänge 4′, 4″ werden mit demselben Modulationssignal versorgt, wobei vor einem der beiden Signaleingänge 4′ oder 4″ ein Signalinverter (nicht abgebildet) angeordnet ist, der dafür sorgt, daß an jedem der beiden Signaleingänge eine Modulationsspannung $U_m$ mit gleichem Betrag und entgegengesetztem Vorzeichen anliegt.

Der Trägereingang 2 der Doppelmodulatorstufe 1 ist entsprechend des Betrages der Modulationsspannung $U_m$, z.B. bei positiver Modulationsspannung $U_m$ am Signaleingang 4′ und negativer Modulationsspannung $U_m$ am Signaleingang 4″ über den elektrisch kurzen Weg 7′ der Teilmodulatorstufe 1′ und über den Phasenverzögerungsweg 6″ der Teilmodulatorstufe 1″ und den Übertrager 11 mit dem Signalausgang 3 verbunden. Bei entgegengesetztem Vorzeichen der Modulationsspannung $U_m$ an den Signaleingängen 4′, 4″ erfolgt die Verbindung über den Phasenverzögerungsweg 6′ der Teilmodulatorstufe 1′ und den elektrisch kurzen Weg 7″ der Teilmodulatorstufe 1″.

Es ist auf jeden Fall gewährleistet, daß die Übertragung jeweils über einen elektrisch kurzen Weg 7′, 7″ und einen Phasenverzögerungsweg 6″, 6′ erfolgt. Auf diese Weise werden technische Unzulänglichkeiten der Teilmodulatorstufen 1′, 1″ kompensiert, die Gruppenlaufzeiten sind in jedem Schaltzustand nahezu gleich und die Doppelmodulatorstufe 1 verhält sich weitgehend temperaturstabil und innerhalb der für den Richtfunk vorgesehenen Trägerfrequenzen amplitudenlinear und frequenzunabhängig.

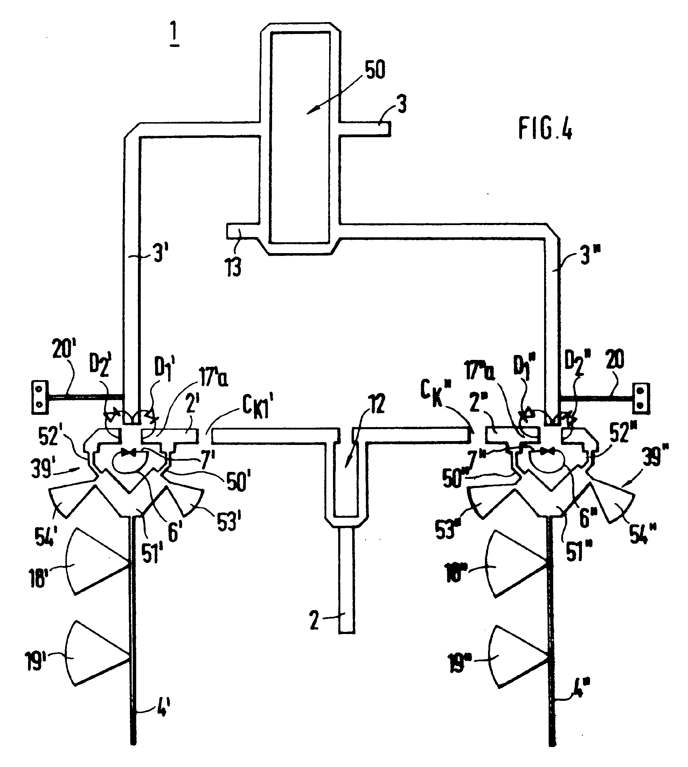

Ein zweites Ausführungsbeispiel, eine Doppelmodulatorstufe 1 ist in Fig. 4 abgebildet. Sie weist die gleichen Funktionseinheiten wie die in Fig. 3 abgebildete Doppelmodulatorstufe 1 auf, ist aber konkret für einen Träger $U_c$ mit einer Frequenz im Gigahertzbereich und für eine Modulationsspannung $U_m$ mit einer Frequenz im Megahertzbereich in planarer Streifenleitertechnik ausgelegt. Die Anordnung der Funktionseinheiten entspricht der aus Fig. 3. Gegenüber Fig. 3 sind gleiche Funktionseinheiten auch mit gleichen Bezugszeichen versehen.

Die Doppelmodulatorstufe 1 weist zwei Teilmodulatorstufen 1′, 1″ mit einem gemeinsamen Trägereingang 2 und einem gemeinsamen Signalausgang 3 auf. Die Trägerspannung $U_c$ liegt am Trägereingang 2′, 2″ der beiden Teilmodulatorstufen 1′, 1″ über einen sogenannten Wilkinsonkoppler 12 an. Die beiden Trägereingange 2′, 2″ sind dabei jeweils über eine Kapazität $C_{K1}'$, $C_{K1}''$ vom Wilkinsonkoppler 12′, 12″ galvanisch getrennt. Die Signalausgänge 3′, 3″ werden über einen 180°-Leistungskombinator 50 in Form eines sogenannten Rate Race Ring zusammengeführt.

Der Rate Race Ring 50 weist als Eingang die beiden Signalausgänge 3′, 3″ der Teilmodulatorstufen 1′, 1″, als Ausgang den Ausgang 3 der Doppelmodulatorstufe 1 und einen 50 Ohm Abschluß 13 gegen Masse auf, er bewirkt ein nochmaliges Verschieben der Phasen der aus der Teilmodulatorstufe 1′ austretenden modulierten Trägerspannung $U_{mc}'$ gegenüber der aus der Teilmodulatorstufe 1″ austretenden Trägerspannung $U_{mc}''$ von 180° und führt diese somit phasenrichtig zusammen.

Die beiden Teilmodulatorstufen 1′, 1″ sind wie die Modulatorstufe 70 aufgebaut, wobei die Teilmodulatorstufe 1′ gegenüber der Teilmodulatorstufe 1″ spiegelsymmetrisch ausgebildet ist.

Das zweite Ausführungsbeispiel ist in planarer Streifenleitertechnik aufgebaut und mit den Dioden $D_1'$, $D_1''$, $D_2'$, $D_2''$ bestückt.

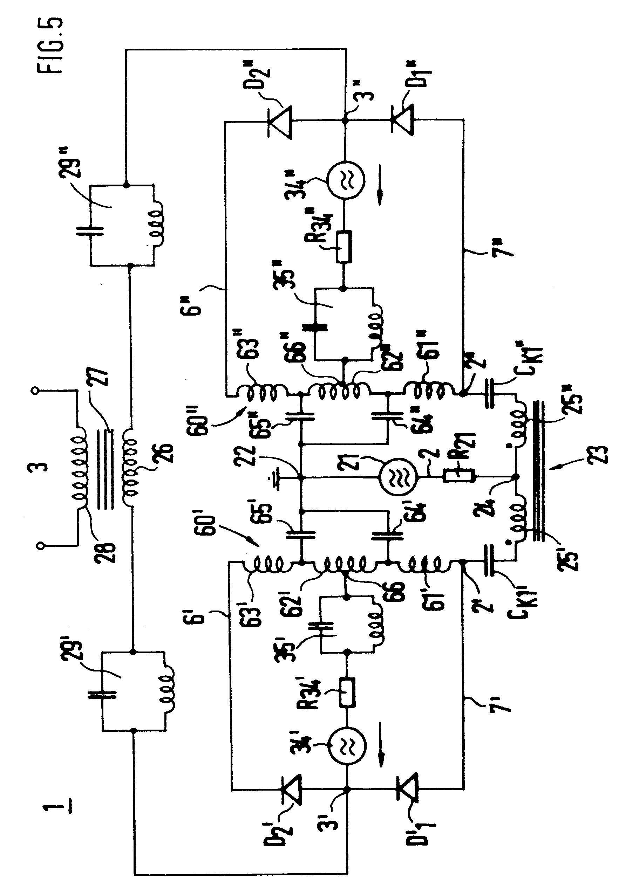

Ein drittes Ausführungsbeispiel ist in Fig. 5 abgebildet. Für die abgebildete Doppelmodulatorstufe 1 gilt, wie auch für die Doppelmodulatorstufe aus Fig. 4, daß sie die gleichen Funktionseinheiten wie die aus Fig. 3 abgebildete aufweist. Gleiche Merkmale sind daher auch mit gleichen Bezugszeichen versehen. Konkret ist sie für einen Träger $U_c$ mit einer Wellenlänge im oberen Megahertzbereich und einer entsprechend niedrigeren Frequenz des Modulationssignals $U_m$ ausgelegt.

Die Doppelmodulatorstufe 1 weist zwei Teilmodulatorstufen 1′, 1″ mit einem gemeinsamen Signalausgang 3 auf. Der Träger $U_c$ wird im Oszillator 21 erzeugt, der auf der einen Seite an Masse 22 liegt und über die andere Seite mit den Trägereingängen 2′, 2″ verbunden ist. Zwischen dem Oszillator 21 und den Trägereingängen 2′ und 2″ liegt ein Spartransformator 23. Dabei liegt der Oszillator 21 an der Anzapfung 24 an und die beiden Wicklungsenden 25′ und 25″ sind über Koppelkondensatoren $C_{K1}'$ und $C_{K1}''$ mit den Trägereingängen 2′, 2″

4

verbunden. Der Spartransformator 23 stellt einen 0°-Leistungsteiler und der Widerstand $R_{21}$ den Innenwiderstand des Oszillators 21 dar.

Die Signalausgänge 3', 3″ sind mit den beiden Wicklungsenden der Primärwicklung 26 eines Transformators 27 verbunden, der als Übertrager 11 dient. Die Wicklungsenden der Sekundärwicklung stellen den Signalausgang 3 der Doppelmodulatorstufe 1 dar. Zur Unterdrückung der Modulationsspannung $U_m$ am Signalausgang 3 sind jeweils zwischen den Wicklungsenden der Primärspule 26 und den Signalausgängen 3' und 3″ für das Modulationssignal $U_m$ hochohmige Parallelschwingkreise 29', 29″ angeordnet.

Jede der beiden Teilmodulatorstufen 1', 1″ weist einen Phasenverzögerungsweg 6', 6″ und einen elektrisch kurzen Weg 7', 7″ auf. Der Phasenverzögerungsweg 6', 6″ weist einen Tiefpaß 60', 60″ und eine Halbleiterdiode $D_2$', $D_2$″ auf. Der Tiefpaß 60', 60″ ist aus diskreten Bauelementen aufgebaut und besteht aus drei in Reihe geschalteten Induktivitäten 61', 61″, 62', 62″, 63', 63″ und jeweils zwischen den Induktivitäten anliegende Kapazitäten 64', 64″, 65', 65″, die mit Masse gekoppelt sind. Die mittlere Induktivität 62', 62″ weist eine Anzapfung 66', 66″ zur Einspeisung des Modulationssignals $U_m$', $U_m$″ auf. Der elektrisch kurze Weg 7', 7″ weist eine Halbleiterdiode $D_1$' $D_1$″ auf. Die Polarität der Dioden entspricht der der übrigen Ausführungen.

Zwischen dem Signalausgang 3', 3″ und der Anzapfung 66', 66″ wird das Modulationssignal in einem Generator 34', 34″ erzeugt, der am Ausgang 3', 3″ anliegt und über einen Parallelschwingkreis 35', 35″ mit der Anzapfung 33', 33″ verbunden ist. Die Widerstände $R_{34}$', $R_{34}$″ stellen die Innenwiderstände der Oszillatoren 34', 34″ dar. Der Parallelschwingkreis 35', 35″ ist für den Träger $U_c$ hochohmig.

Der Tiefpaß 60', 60″ und die beiden Halbleiterdioden $D_1$', $D_2$'; $D_1$″, $D_2$″ wirken wie eine Wheatstonsche Brücke, bei der zwischen dem Ausgang 3', 3″ und der Anzapfung 66', 66″ Gleichgewicht herrscht, solange keine Modulationsspannung $U_m$ anliegt. Liegt dagegen eine Modulationsspannung $U_m$ an, wird das Gleichgewicht der Brücke aufgehoben und am Ausgang 3', 3″ liegt die modulierte Trägerspannung $U_{mc}$ an.

Gerade bei der Ausgestaltung einer Modulatorstufe als Doppelmodulatorstufe ist die Verwendung eines Tiefpasses 39', 39″, 60', 60″ als Phasenverzögerungsglied von besonderer Bedeutung, da er als Teil dieser komplexeren Schaltung viele Freiheitsgrade in der Anordnung und Ausbildung zuläßt.

In Fig. 6 ist die an und für sich bekannte schematische Darstellung eines 16 QAM-Modulator 49 (Quadratur Amplituden Modulation) für eine Bitfolgefrequenz von 140 MBit/s abgebildet. Er besteht im wesentlichen aus zwei Doppelmodulatorstufen 40, 41, wobei die eine Doppelmodulatorstufe 40 das Signal für die I-Komponente und die Doppelmodulatorstufe 41 das Signal für die Q-Komponente liefert. Im Leistungskombinator 42 werden die beiden Komponenten orthogonal zusammengeführt.

Der Ausgang 43 des Leistungskombinators 42 bildet den Ausgang des 16 QAM-Modulators 49. Der Träger $U_c$ liegt an den Trägereingängen 2 der beiden Modulatorstufen 40, 41 über einen sogenannten Wilkinsonkoppler 45 an. An den Signaleingängen 46, 47 der beiden Doppelmodulatorstufen 40, 41 liegen jeweils die Modulationssignale für die I- bzw. Q-Komponenten, wobei jeweils an einer Doppelmodulatorstufe 40, 41 für die I- bzw. Q-Komponente ein Modulationssignal $U_m$ mit gleichem Betrag und entgegengesetzten Vorzeichen anliegt.

Als Halbleiterdioden $D_1$', $D_1$″, $D_2$', $D_2$″ eignen sich besonders Schottkydioden, die z.B. gegenüber Pindioden kürzere Verzögerungszeiten aufweisen. Die Temperaturabhängigkeit der Dioden wird durch die paarweise Anordnung in der Brückenschaltung kompensiert. Herstellungsbedingte Unterschiede der Dioden sind z.B. durch Anlegen einer Gleichspannung über den regelbaren Widerstand am Signaleingang auszugleichen und damit die Trägerunterdrückung zu optimieren. Die regelbaren Widerstände $R_R$', $R_R$″ werden jeweils so eingestellt, daß bei nicht Anlegen der Modulationsspannung $U_m$ in jeder Teilmodulatorstufe 1', 1″, 70 Brückengleichgewicht herrscht.

Die beschriebene Modulatorstufe 1 kann auch als Sende- oder Empfangsmischstufe (nicht abgebildet) betrieben werden. Als ein Beispiel wird die Verwendung der Modulatorstufe 1 des ersten Ausführungsbeispiels als Sendemischstufe herangezogen. Die im ersten Ausführungsbeispiel beschriebenen Signaleingänge 4' und 4″ sind dabei zur Einkopplung des in seiner Frequenz umzusetzenden Signals vorgesehen. Für den Fall, daß die Polarität des Diodenpaares $D_1$', $D_2$', bezogen auf den Trägereingang 2″, wie in Fig. 4 abgebildet, der des Diodenpaares $D_1$″, $D_2$″ entspricht, muß das in seiner Frequenz umzusetzende Signal an einem der beiden Signaleingänge invertiert werden. Für den Fall, daß die Polarität des Diodenpaares $D_1$', $D_2$', bezogen auf den Trägereingang 2″, der des Diodenpaares $D_1$″, $D_2$″ nicht entspricht, können die beiden Signaleingänge direkt miteinander verbunden sein.

Entsprechendes gilt auch für die Verwendung des 16 QAM Modulators 49 als Mischer, der empfangsseitig als spiegelunterdrückender Mischer und sendeseitig als Einseitenbandmischer betrieben werden kann. Hierzu ist es allerdings bei der Ausnützung beider Kopplungszweige I und Q notwendig, diese über einen 90°-Leistungskombinator miteinander zu verbinden.

Die Verwendung einer Modualtorstufe als Mischstufe ist prinzipiell bekannt und bedarf daher keiner weiteren Erläuterung.

**Patentansprüche**

1. Modulatorstufe (1) zum Bilden eines modulierten Trägersignales aus einem Träger und einem Modulationssignal mit einem Träger- und einem Signaleingang (2,2',2" ; 4,4',4") und einem Signalausgang (3,3',3"),
   - bei der vom Trägereingang (2,2',2") zum Signalausgang (3,3',3") ein elektrisch kurzer Weg (7,7',7") und ein Phasenverzögerungsweg führen (6,6',6"),
   - bei der die Phase des Trägers im Phasenverzögerungsweg (6,6',6") gegenüber der Phase des Trägers im elektrisch kurzen Weg (7,7',7") eine Phasenverschiebung von etwa 180° oder ein ungeradzahliges, ganzes Vielfaches von 180° erfährt,
   - bei der auf dem Phasenverzögerungsweg (6,6',6") ein Phasenverzögerungsglied angeordnet ist,
   - bei der sich auf jedem der beiden Wege (6,6',6" ; 7,7',7") ein nichtlineares Halbleiterbauelement ($D_1$,$D_2$) befindet, die bezüglich der Ausbreitungsrichtung des Trägers entgegengesetzte Polarität aufweisen und auf den beiden Wegen so angeordnet sind, daß sie hinsichtlich des Trägers im Gleichtakt betreibbar sind, und
   - bei der der Signaleingang (4,4',4") mit dem Phasenverzögerungsweg (6,6',6") derart verbunden ist, daß die Modulatorstufe (1) hinsichtlich des Signals im Gegentakt betreibbar ist,
   **dadurch gekennzeichnet,**
   - daß das Phasenverzögerungsglied als Tiefpaß (39) mit vorgegebenen Tiefpaß eigenschaften ausgebildet ist.

2. Modulatorstufe nach Anspruch 1, dadurch gekennzeichnet, daß der Tiefpaß (39) aus einer ungeradzahligen Anzahl von Elementen besteht und an jedem Ende des Phasenverzögerungsweges (6) eine Induktivität (50, 52) angeordnet ist.

3. Modulatorstufe nach Anspruch 2, dadurch gekennzeichnet, daß der Tiefpaß (39) aus drei in Reihe geschalteten Induktivitäten (50, 51, 52) besteht, zwischen denen jweils eine mit Masse gekoppelte Kapazität (53, 54) angeordnet ist.

4. Modulatorstufe nach einem der Ansprüche 1 bis 3, dadurch gekennzeichnet, daß die Grenzfrequenz ($f_G$) des Tiefpasses (39) etwa der 2ten Harmonischen der Trägerfrequenz ($f_c$) entspricht.

5. Modulatorstufe nach einem der vorhergehenden Ansprüche 1 bis 4, dadurch gekennzeichnet, daß sie als monolithisch integrierte Mikrowellenschaltung (MMIC) vorgesehen ist.

6. Modulatorstufe nach einem der vorhergehenden Ansprüche 1 bis 4, dadurch gekennzeichnet, daß sie wenigstens überwiegend in planarer Streifenleiterstruktur ausgebildet ist.

7. Modulatorstufe nach einem der vorhergehenden Ansprüche 1 bis 6, dadurch gekennzeichnet,
   - daß die Modulatorstufe als aus zwei Teilmodulatorstufen (1', 1") bestehende Doppelmodulatorstufe (1) ausgebildet ist,
   - daß die beiden Trägereingänge (2', 2") und die beiden Signalausgänge (3', 3") der beiden Teilmodulatorstufen (1', 1") jeweils miteinander verbunden sind,
   - daß an den Signaleingängen (4', 4") die gleichen Signale mit gleichem Betrag aber entgegengesetztem Vorzeichen anliegen,
   - und daß eine Vorrichtung (11, 23) zur skalaren Addition der um 180° phasenverschobenen modulierten Trägerspannung ($U_{mc}'$, $U_{mc}"$) der Teilmodulatorstufen 1' und 1" vorgesehen ist.

8. Modulatorstufe nach Anspruch 7, dadurch gekennzeichnet, daß die Vorrichtung (11) zur skalaren Addition ein zwischen den Ausgängen (3', 3") der Teilmodulatorstufen (1', 1") und dem Ausgang (3) der Doppelmodulatorstufe (1) angeordneter 180°-Koppler (11) ist.

9. Modulatorstufe nach Anspruch 1, dadurch gekennzeichnet, daß jeder Signaleingang (4, 4', 4") der Modulatorstufen (39, 1', 1") mit einem regelbaren Widerstand ($R_R'$, $R_R"$), zum Abgleich der Modulatorstufe angeordnet ist.

10. Modulatorstufe nach Anspruch 1, dadurch gekennzeichnet, daß das nichtlineare Halbleiterbauelement ($D_1$, $D_2$, $D_1'$, $D_2'$, $D_1"$, $D_2"$) eine Schottkydiode ist.

**11.** Modulatorstufe nach Anspruch 1, dadurch gekennzeichnet, daß die Modulatorstufen (39, 1′, 1″) als amplitudenlineare Phasenumschalter ausgebildet sind.

**12.** Modulatorstufe nach einem der vorhergehenden Ansprüche 1 bis 11, dadurch gekennzeichnet, daß sie als Mischstufe verwendet wird.

**Claims**

**1.** Modulator stage (1) for forming a modulated carrier signal from a carrier and a modulation signal, having a carrier input and a signal input (2, 2′, 2″; 4, 4′, 4″) and a signal output (3, 3′, 3″)
- in which an electrically short path (7, 7′, 7″) and a phase delay path (6, 6′, 6″) run from the carrier input (2, 2′, 2″) to the signal output (3, 3′, 3″),
- in which the phase of the carrier undergoes a phase shift of about 180° or an odd whole multiple of 180° in the phase delay path (6, 6′, 6″) with respect to the phase of the carrier in the electrically short path (7, 7′, 7″),
- in which a phase delay element is disposed on the phase delay path (6, 6′, 6″),
- in which there is situated on each of the two paths (6, 6′, 6″, 7, 7′, 7″) a nonlinear semiconductor component $(D_1, D_2)$ which has opposite polarity with respect to the direction of propagation of the carrier and is disposed on the two paths in such a way that they can be driven in push-pull with respect to the carrier.

**2.** Modulator stage according to Claim 1, characterized in that the low-pass filter (39) comprises an odd number of components and an inductance (50, 52) is disposed at each end of the phase delay path (6).

**3.** Modulator stage according to Claim 2, characterized in that the low-pass filter (39) comprises three inductances (50, 51, 52) connected in series, between which a capacitance (53, 54) coupled to earth is disposed in each case.

**4.** Modulator stage according to one of Claims 1 to 3, characterized in that the cutoff frequency $(f_G)$ of the low-pass filter (39) corresponds approximately to the second harmonic of the carrier frequency $(f_c)$.

**5.** Modulator stage according to one of the preceding Claims 1 to 4, characterized in that it is provided as monolithic integrated microwave circuit (MMIC).

**6.** Modulator stage according to one of the preceding Claims 1 to 4, characterized in that it is designed, at least predominantly, in a planar strip-line structure.

**7.** Modulator stage according to one of the preceding Claims 1 to 6, characterized
- in that the modulator stage is designed as double modulator stage (1) comprising two component modulator stages (1′, 1″),
- in that the two carrier inputs (2′, 2″) and the two signal outputs (3′, 3″) of the two component modulator stages (1′, 1″) are in each case interconnected,
- in that the same signals having the same absolute value but opposite sign are present at the signal inputs (4′, 4″),
- and in that a device (11, 23) for the scalar addition of the carrier voltages $(U_{mc}′, U_{mc}″)$ of the component modulator stages 1′ and 1″ is provided, which carrier voltage $(U_{mc}′, U_{mc}″)$ is phase-shifted by 180°.

**8.** Modulator stage according to Claim 7, characterized in that the device (11) for the scalar addition is a 180° coupler (11) disposed between the outputs (3′, 3″) of the component modulator stages (1′, 1″) and the output (3) of the double modulator stage (1).

**9.** Modulator stage according to Claim 1, characterized in that each signal input (4, 4′, 4″) of the modulator stages (39, 1′, 1″) is fitted with a variable resistor $(R_R′, R_R″)$ for aligning the modulator stage.

**10.** Modulator stage according to Claim 1, characterized in that the nonlinear semiconductor component $(D_1, D_2, D_1′, D_2′, D_1″, D_2″)$ is a Schottky diode.

**11.** Modulator stage according to Claim 1, characterized in that the modulator stages (39, 1′, 1″) are designed as amplitude-linear phase switches.

12. Modulator stage according to one of the preceding Claims 1 to 11, characterized in that it is used as a mixer stage.

**Revendications**

1. Etage modulateur (1) pour la formation d'un signal de porteuse modulé à partir d'une porteuse et d'un signal de modulation, comportant une entrée de porteuse et une entrée de signal (2, 2', 2"; 4, 4', 4") et une sortie de signal (3, 3', 3"),
   - selon lequel un chemin électriquement court (7, 7', 7") et un chemin à retard de phase (6, 6', 6") conduisent de l'entrée de porteuse (2, 2', 2") à la sortie de signal (3, 3', 3");
   - selon lequel la phase de la porteuse subit dans le chemin à retard de phase (6, 6', 6") contrairement à la phase dans le chemin électriquement court (7, 7' 7") un déphasage d'environ 180° ou d'un multiple entier impair de 180°;
   - selon lequel un opérateur à retard de phase est disposé sur le chemin à retard de phase (6, 6', 6");
   - selon lequel un élément à semi-conducteur non-linéaire ($D_1$, $D_2$) se trouve sur chacun des deux chemins (6, 6', 6"; 7, 7', 7"), lesquels éléments présentent par rapport au sens de propagation de la porteuse, une polarité inversée et sont disposés sur les deux chemins de façon telle qu'ils puissent fonctionner en mode commun par rapport à la porteuse.

2. Etage modulateur selon la revendication 1, caractérisé en ce que le passe-bas (39) comporte un nombre impair d'éléments et en ce qu'une inductance (50, 52) est disposée à chaque extrémité du chemin à retard de phase (6).

3. Etage modulateur selon la revendication 2, caractérisé en ce que le passe-bas (39) comporte trois inductances (50, 51, 52) montées en série, entre lesquelles une capacité (53, 54) mise à la masse est chaque fois disposée.

4. Etage modulateur selon l'une des revendications 1 à 3, caractérisé en ce que la fréquence limite ($f_G$) du passe-bas (39) correspond sensiblement au deuxième harmonique de la fréquence porteuse ($f_c$).

5. Etage modulateur selon l'une des revendications précitées 1 à 4, caractérisé en ce qu'il est prévu comme circuit intégré monolithique à micro-ondes (MMIC).

6. Etage modulateur selon l'une des revendications précitées 1 à 4, caractérisé en ce qu'il est connu au moins principalement comme une structure planaire à microbandes.

7. Etage modulateur selon l'une des revendications précitées 1 à 6, caractérisé
   - en ce que l'étage modulateur est conçu sous forme d'étage modulateur double (1) comportant deux étages modulateurs partiels (1', 1"),
   - en ce que les deux entrées de porteuse (2', 2") et les deux sorties de signal (3', 3") des deux étages modulateurs partiels (1', 1") sont reliées entre elles,
   - en ce que les mêmes signaux de valeur identique mais à signe inverse sont placés sur les entrées de signal (4', 4"), et
   - en ce qu'un dispositif (11, 23) est prévu pour l'addition scalaire de la tension de porteuse ($U_{mc}'$, $U_{mc}"$) modulée et déphasée de 180° des étages modulateurs partiels 1' et 1".

8. Etage modulateur selon la revendication 7, caractérisé en que le dispositif (11) pour l'addition scalaire est un coupleur de 180° (11) qui est disposé entre les sorties (3', 3") des étages modulateurs partiels (1', 1") et la sortie (3) de l'étage modulateur double (1).

9. Etage modulateur selon la revendication 1, caractérisé en ce que chaque entrée de signal (4, 4', 4") des étages modulateurs (39, 1', 1") est pourvue d'une résistance réglable (RR', RR") pour l'équilibrage de l'étage modulateur.

10. Etage modulateur selon la revendication 1, caractérisé en ce que l'élément à semi-conducteur non linéaire ($D_1$, $D_2$, $D_1'$, $D_2'$, $D_1"$, $D_2"$) est une diode de Schottky.

11. Etage modulateur selon la revendication 1, caractérisé en ce que les étages modulateurs (39, 1', 1'') se présentent sous forme d'inverseurs de phase linéaires en amplitude.

12. Etage modulateur selon l'une des revendications précédentes 1 à 11, caractérisé en ce qu'il est utilisé comme étage mélangeur.

<u>70</u>

52    54

FIG.1

D2

3

Umc

6

Um

4

D1

7

51

39

50

53

2    Uc

<u>39</u>

50    51    52

0°    53    54    180°

FIG.2

FIG.3

FIG.6

FIG.4

FIG.5

EP 0 480 145 B1